(19) Europäisches Patentamt
European Patent Office
Office européen des brevets

(11) **EP 1 056 178 B1**

(12) **EUROPÄISCHE PATENTSCHRIFT**

(45) Veröffentlichungstag und Bekanntmachung des Hinweises auf die Patenterteilung:
**04.07.2012 Patentblatt 2012/27**

(51) Int Cl.:
***H02H 3/16*** *(2006.01)*

(21) Anmeldenummer: **00109340.0**

(22) Anmeldetag: **02.05.2000**

(54) **Schaltungsanordnung für die Überwachung von Erdschlüssen an einem Ofen, der ein dreiphasiges Heizsystem aufweist**

Circuit for monitoring earth faults in a furnace in a three phase heating system

Circuit pour détecter des défauts à la terre d'un four d'un système de chauffage triphasé

(84) Benannte Vertragsstaaten:
**AT BE CH CY DE DK ES FI FR GB GR IE IT LI LU MC NL PT SE**

(30) Priorität: **26.05.1999 DE 19924106**

(43) Veröffentlichungstag der Anmeldung:
**29.11.2000 Patentblatt 2000/48**

(73) Patentinhaber: **ALD Vacuum Technologies Aktiengesellschaft**
**63450 Hanau (DE)**

(72) Erfinder: **Felski, Peter, Dipl.-Ing. (FH)**
**63450 Hanau (DE)**

(74) Vertreter: **Hebing, Norbert**
**Patentanwalt**
**Frankfurter Strasse 34**
**61231 Bad Nauheim (DE)**

(56) Entgegenhaltungen:
**EP-A- 0 291 156    US-A- 3 764 855**

**Beschreibung**

Die Erfindung betrifft einen Ofen mit einem dreiphasigen Heizsystem, nach dem Oberbegriff des Patentanspruchs 1.

In Vakuumöfen werden oft dreiphasige Heizungssysteme eingesetzt, die über einen Drehstromtransformator an ein Drehstromnetz angeschlossen sind. Die Spannung des Drehstromnetzes beträgt dabei mehrere Hundert oder Tausend Volt, während am Ausgang des Drehstromtransfomators nur etwa 50 Volt anliegen.

Die für die Vakuumöfen erforderliche Heizleistung liegt im Bereich von einigen kW bis zu einem MW. Wegen der geringen Ausgangsspannung des Transformators müssen hohe Ströme von mehreren Tausend Ampère vom Transformator zur Heizung übertragen werden. Hierfür werden Hochstromkabel verwendet, die oftmals wassergekühlt ausgeführt sind. Diese Kabel werden isoliert durch das Gehäuse des Ofens geführt.

Tritt bei einem derart mit Hochstrom gespeisten Vakuumofen ein Erdschluss auf, beispielsweise wenn die Isolierung im Gehäuse defekt ist, durch welche ein Hochstromkabel geführt wird, so fliesst ein hoher Strom von der Zuleitung des Heizsystems über das Gehäuse zur Erde. Eine Zerstörung des Gehäuses oder der Gehäusedurchführung kann die Folge sein.

Es ist bereits ein dreiphasiges Heizsystem bekannt, das über einen Transformator aus einem Drehstromnetz gespeist wird (US-PS 5 811 767, Fig. 9). Bei diesem Heizsystem sind verdrillte Sternleitungen mit einer herkömmlichen 3-Phasenversorgung verbunden. Die Niedervoltspannung auf der Ausgangsseite beträgt 30 Volt oder weniger, wobei der Transformator eine Leistung von 10 kVA besitzt und somit 200 A bereitstellt. Bei grossen Anlagen können mehrere Transformatoren zum Einsatz kommen, wobei jeder dieser Transformatoren mit dem Netz verbunden ist. Eine Einrichtung für die Überwachung von Erdschlüssen weist dieses Heizsystem jedoch nicht auf.

Es ist indessen auch bekannt, Kurz- und Erdschlüsse in elektrischen Netzen zu vermeiden und zu bekämpfen (Flosdorff/Hilgarth: Elektrische Energieverteilung, Stuttgart 1986, S. 96 ff.). So ist eine Erdschlussmeldeschaltung bekannt, die einen dreiphasigen Erdungs-Spannungswandlersatz, ein Erdschlussmelderelais und mehrere Spannungsmesser aufweist (a. a. O., S. 199). Wie Erdschlüsse bei Heizungsöfen der vorstehend beschriebenen Art bekämpft werden können, ist indessen nicht angegeben.

Erdschlussüberwachungssysteme wie sie in der Haustechnik oder in bestimmten Industriebereichen zu finden sind (vgl. z. B. Siemens-Firmenschrift: Der Erschluss im Netzbetrieb, S. 8, 9; DE 39 21 063 C1), sind für den Anwendungsfall Vakuumöfen nicht geeignet, da sie nur Erdströme im μA- oder im mA-Bereich detektieren. Derart empfindliche Systeme lösen unnötig früh aus und stören die Betriebsabläufe.

Bei einem bekannten Erdschluss-Erfassungssystem für Öfen wird ein Gleichstrom eingespeist, um Erdschlüsse zu erkennen (EP 0 291 156 A1).

In der US 3,764,855 ist ein Erdschlussüberwachungssystem beschrieben, bei dem parallel zum Drehstromnetz Primärspulen in einer Sternschaltung geschaltet sind, deren Mittenabgriff geerdet ist. Die Primärspulen sind jeweils mit einer Sekundärspule gekoppelt, wobei die Sekundäzspulen in einer Dreiecksschaltung vorliegen. In dem von der Dreiecksschaltung gebildeten Kreis befinden sich eine Sicherung sowie Warneinrichtungen.

Der Erfindung liegt die Aufgabe zugrunde, einen Ofen mit einem Erdschlussüberwachungssystem zu schaffen, das störunempfindlich ist und zuverlässig auslöst, ohne dass hierfür ein Gleichstrom in das System eingespeist werden muss.

Diese Aufgabe wird gemäß den Merkmalen des Patentanspruchs 1 gelöst.

Die Erfindung betrifft somit einen Ofen, der ein dreiphasiges Heizsystem aufweist mit einer Schaltungsanordnung für die Überwachung von Erdschlüssen. Dieses Heizsystem wird aus einer dreiphasigen Spannungsquelle versorgt, wobei parallel zu dieser Spannungsquelle verkettete Induktivitäten vorgesehen sind. Diese Induktivitäten können im Stern, im Dreieck oder als Zickzackschaltung geschaltet sein. Besteht die Spannungsquelle aus einem dreiphasigen Transformator, kann dieser ein Dreieck-Stern-, Dreieck-Dreieck-, Stern-Stern- etc. Transformator sein. Die Last kann ebenfalls auf verschiedene Art geschaltet sein und verschiedene Lastgrössen, z. B. ohmsche Widerstände, Induktivitäten etc., beinhalten.

Der mit der Erfindung erzielte Vorteil besteht insbesondere darin, dass ein Erdschluss in einer der drei Phasen eindeutig detektiert wird. Die Empfindlichkeit des Detektierens kann durch vorgegebene Auslösewerte, z. B. innerhalb eines Bereichs von 6 A bis 32 A, und Auslösecharakteristik von Schutzschaltern vorgewählt werden. Ein weiterer Vorteil der Erfindung besteht darin, dass sie kostengünstig in Alt-Anlagen nachrüstbar ist, weil nur wenige Komponenten benötigt werden. Des Weiteren ist der Gegenstand der Erfindung sehr robust, sodass er in Industrieanlagen und im Ofenbau eingesetzt werden kann.

Ausführungsbeispiele der Erfindung sind in den Zeichnungen dargestellt und werden im Folgenden näher beschrieben. Es zeigen:

Fig. 1    eine schematische Darstellung eines Ofens mit einer dreiphasigen Heizung und einer Erdschlussüberwachung, wobei die Sekundärseite eines Trans- formators, die Heizung und die Erdschlussüberwachung im Stern ge-

schal- tet sind;

Fig. 2     eine schematische Darstellung wie in Fig. 1, jedoch mit einem sekundär- seitig im Dreieck geschalteten Transformator;

Fig. 3     eine schematische Darstellung wie in Fig. 1, jedoch mit einer Heizung in Dreieckschaltung;

Fig. 4     eine schematische Darstellung wie in Fig. 1, jedoch mit einer der Sekun- därseite des Transformators und der Heizung in Dreieckschaltung;

Fig. 5     eine schematische Darstellung wie in Fig. 1, jedoch mit einer Erdschluss- überwachung in Zick-Zack-Schaltung;

Fig. 6     eine schematische Darstellung wie in Fig. 1, jedoch mit einer Dreieck- schaltung der Sekundärseite des Transformators und einer Zick-Zack- Schaltung der Erdschlussüberwachung;

Fig. 7     eine schematische Darstellung wie in Fig. 1, jedoch mit einer Heizung in Dreieckschaltung und einer Erdschlussüberwachung in Zick-Zack-Schal- tung;

Fig. 8     eine schematische Darstellung wie in Fig. 1, mit der Sekundärseite des Transformators und der Heizung in Dreieckschaltung sowie der Erd- schlussüberwachung in Zick-Zack-Schaltung.

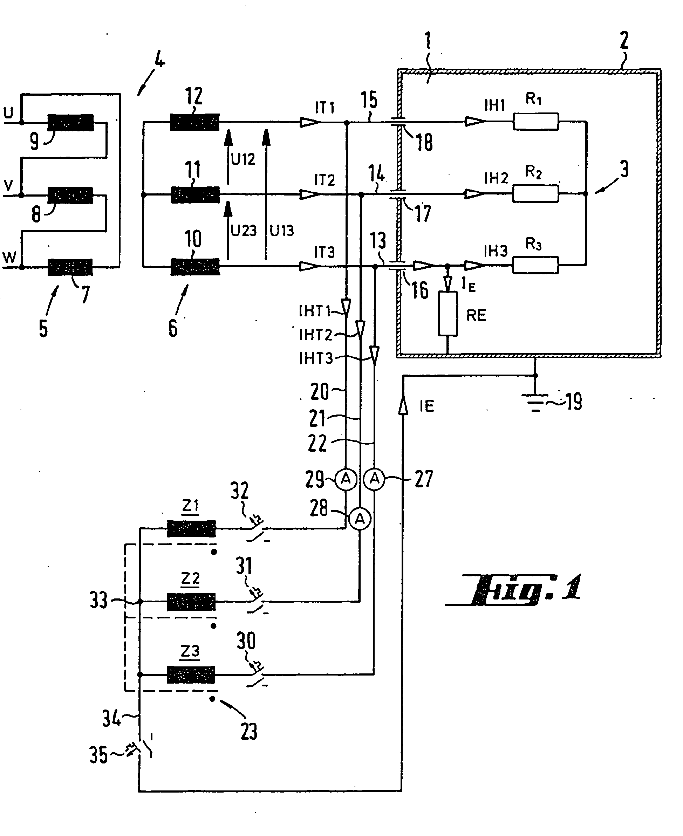

In der Fig. 1 ist eine Schaltungsanordnung zum Ermitteln von Erdschlüssen an Öfen mit elektrischer Heizung dargestellt. Im Innenraum 1 eines Ofengehäuses 2 befinden sich drei ohmsche Widerstände R1, R2, R3, die zur Aufheizung des Innenraums 1 dienen. Diese ohmschen Widerstände R1, R2, R3 werden durch Drehstrom versorgt und sind Teil einer Sternschaltung 3. Der die Widerstände R1, R2, R3 versorgende Drehstrom wird von einem Drehstromtransformator 4 geliefert, dessen Primärseite 5 im Dreieck und dessen Sekundärseite 6 im Stern geschaltet sind.

Mit 7, 8, 9 sind die Primärwicklungen des Drehstromtransformators 4 bezeichnet, während die Sekundärwicklungen dieses Transformators 4 mit den Bezugszahlen 10, 11, 12 versehen sind. Der Drehstromtransformator 4 wird seinerseits aus einem Drehstromnetz versorgt, dessen Leitungen mit U, V, W bezeichnet sind.

Die von den Sekundärwicklungen 10, 11, 12 zu den Heizwiderständen R1, R2, R3 führenden Leitungen sind Hochstromleitungen 13, 14, 15, die durch elektrisch isolierte Öffnungen 16 bis 18 in den Innenraum 1 des Gehäuses 2 eingeführt sind. Da dieses Gehäuse 2 geerdet ist, fließt dann, wenn z. B. die Isolation an der Öffnung 16 defekt ist, ein Strom von der Hochstromleitung 13 zur Erde 19. Der Widerstand, über den der Strom fließt, ist durch den Ersatzwiderstand RE angedeutet.

An die Hochstromleitungen 13, 14, 15 sind Leitungen 20 bis 22 einer Sternschaltung 23 angeschlossen, wobei diese Sternschaltung 23 Induktivitäten Z1, Z2, Z3 aufweist. Die Induktivitäten Z1, Z2, Z3 sind verkettet, d. h. sie befinden sich auf einem gemeinsamen Eisenkern. Diese Verkettung bedeutet, dass die Gegeninduktivitäten berücksichtigt werden müssen. In Serie zu jeder dieser Induktivitäten Z1, Z2, Z3 liegen Sicherungen bzw. Schutzschalter 30, 31, 32 und fakultativ Strommessgeräte 27, 28, 29. Von dem Sternpunkt 33 der Sternschaltung 23 führt eine Leitung 34 zu dem geerdeten Gehäuse 2. In dieser Leitung 34 befindet sich ein Trennschalter 35, mit dem es möglich ist, die Leitung 34 zu unterbrechen.

Im Normalbetrieb, d. h. wenn kein Erdschluss des Gehäuses 2 vorhanden ist, fließen bei gleich großen Widerständen R1, R2, R3 auch gleich große Ströme IH1, IH2, IH3 durch diese Widerstände R1, R2, R3.

Die durch die Widerstände R1, R2, R3 fließenden Ströme IH1, IH2, IH3 berechnen sich wie folgt:

$$I_{H1} = \frac{U_{13}}{\sqrt{3}\,R_1}$$

$$I_{H2} = \frac{U_{12}}{\sqrt{3}\,R_2}$$

$$I_{H2} = \frac{U_{23}}{\sqrt{3}\,R_3}$$

Entsprechendes gilt für die Ströme, die durch die Induktivitäten Z1, Z2, Z3 fließen. Mit $Z_1 = Z_2 = Z_3 = Z_L$ gilt

$$I_{H1} = \frac{U_{12}}{\sqrt{3}\,Z_L}$$

$$I_{HT2} = \frac{U_{23}}{\sqrt{3}\,Z_L}$$

$$I_{HT3} = \frac{U_{23}}{\sqrt{3}\,Z_L}$$

Gilt außerdem $|U_{12}| = |U_{23}| = |U_{13}| = \sqrt{3}\,U$, so ist auch $|I_{HT1}| = |I_{HT2}| = |I_{HT3}| = I$.

Im Normalbetrieb ist der Sicherungsautomat oder Trennschalter 35 geschlossen. Dasselbe gilt für die Sicherungsautomaten oder Trennschalter 30 bis 32. Der Sternpunkt 33 der Spulen Z1, Z2, Z3 liegt dann auf Erdpotential.

Wesentlich ist, dass das Ofengehäuse 2 geerdet ist. Durch die verketteten Drosselspulen wird ein künstlicher Sternpunkt geschaffen, der im symmetrischen Betrieb, d. h. wenn kein Erdschluss vorliegt, das gleiche Potential aufweist wie das Masse/Erdpotential. Deshalb fließt über die Leitung 34 bzw. den Schalter 30 kein Ausgleichsstrom.

Erfolgt nun ein Kurzschluss zwischen der Leitung 13 und dem Gehäuse 2, so fließt - die Sicherungsautomaten 30 bis 32, 35 sind zunächst noch geschlossen - ein Strom über den Kurzschlusswiderstand $R_E$.

Für die Induktivitäten $Z_1$ und $Z_3$ gilt bei vorliegendem Erdschluss $R_E = 0$:

$$|I_{HT1}| = |I_{HT3}| = I = \frac{U}{Z_L} \cdot \sqrt{3}\,\frac{L+M}{L-M} \cdot \frac{1}{\cos(\alpha)}$$

Die Größe a ergibt sich hierbei aus den Werten $R_E$, M und L sowie in der Praxis aus den ohmschen Anteilen der Spulen $L_1$, $L_2$, $L_3$, die jedoch bei der Berechnung vernachlässigt sind. Damit ergibt sich das Verhältnis der Ströme für $R_E = 0$ zu $R_E = \infty$

$$\frac{I_0}{I_\infty} = \sqrt{3} \cdot 3 \cdot \frac{1}{\cos(\alpha)}$$

Der Strom $I_{HT1}$ hat sich somit gegenüber dem Zustand, als kein Erdschluss vorlag, erheblich verändert. Diese Stromänderung kann nun zum Anlass genommen werden, den Ofen abzuschalten. Bei vorliegendem Erdschluss wird das System unsymmetrisch, d. h. der künstliche Sternpunkt der Drosselspulen verschiebt sich, und es fließen Ausgleichsströme sowohl zu den Leitungen 20, 21, 22 als auch in der Leitung 34.

Nachfolgend wird ein Messprotokoll wiedergegeben, welches den Einfluss des Erdschlusses auf die Ströme und Spannungen wiedergibt. Dabei wird von einem Transformator 4 mit einer Leistung von 750 VA ausgegangen, dessen Sekundärspannung 3 x 60 V beträgt. Der Sekundärstrom ist dabei 3 x 7,2 A. Es werden also die tatsächlichen Verhältnisse auf niedrigerem Leistungsniveau simuliert. Man erkennt aus diesem Protokoll beispielsweise, dass die Ströme $I_{HT1}$, $I_{HT2}$ und $I_{HT3}$ umso größer werden, je satter der Erdschluss ist.

MESSPROTOKOLL: ERDSCHLUSSÜBERWACHUNG 3-PHASIG

| Messwerte | | RE/Ohm (kein Erdschluss) | RE/Ohm | RE/Ohm | RE/Ohm | RE/Ohm | RE/Ohm (Kurzschluss) |
|---|---|---|---|---|---|---|---|
| | - | ∞ | 200 | 104 | 64 | 2,2 | 0,03 |
| $R_E$ zwischen: Erde-1 | - | - | - | - | - | - | - |
| $R_E$ zwischen: Erde-2 | - | - | - | - | - | - | - |

(fortgesetzt)

| Messwerte | | RE/Ohm (kein Erdschluss) | RE/Ohm | RE/Ohm | RE/Ohm | RE/Ohm | RE/Ohm (Kurzschluss) |
|---|---|---|---|---|---|---|---|
| $R_E$ zwischen: Erde-3 | - | - | X | X | X | X | X |
| | | | | | | | |
| U12/V | - | 66,7 | 66,6 | 66,8 | 66,4 | 66,6 | 66,6 |
| U23/V | - | 67 | 66,7 | 66,9 | 66,2 | 62,2 | 65,8 |
| U13/V | - | 67 | 66,9 | 66,7 | 66,3 | 65,3 | 65,8 |
| | | | | | | | |
| IT1/mA | - | 375 | 407 | 439 | 490 | 1190 | 1380 |
| IT2/mA | | 385 | 415 | 450 | 500 | 1130 | 1290 |
| IT2/mA | - | 400 | 515 | 615 | 750 | 2250 | 2620 |
| | | | | | | | |
| IH1/mA | - | 370 | 370 | 370 | 370 | 370 | 370 |
| IH2/mA | - | | 380 375 | 370 | 370 | 370 | 370 |
| IH3/mA | - | 390 | 380 | 375 | 375 | 375 | 375 |
| | | | | | | | |
| IH3, E/mA | - | 390 | 570 | 725 | 900 | 3100 | 3600 |
| IHT1/mA | - | 9,3 | 53,1 | 103 | 170 | 930 | 1100 |
| IHT2/mA | - | 9,4 | 67 | 118 | 184 | 950 | 1140 |
| IHT3 mA | - | 6,2 | 56,5 | 107 | 172 | 950 | 1150 |
| | | | | | | | |
| | | | | | | | |
| $U_E$/V | | 38,5 | 36,6 | 34,9 | 32,4 | 6,38 | 0,097 |
| IE/mA | - | 0 | 183 | 336 | 510 | 2900 | 3300 |

Bei dem durchgeführten Versuch sind die Werte in der Tabelle bei Spannungen in Volt bzw. bei Strömen in mA angegeben, entsprechend den Vorgaben in der ersten Spalte der Tabelle. $R_E$ ist der Kurz- oder Erdschlusswiderstand. Bei den durchgeführten Versuchen wurde der Erdschlusswiderstand verändert, wodurch sich die in der Tabelle gezeigten Werte ergaben. Die Spannungen $U_{12}$, $U_{23}$, $U_{13}$ waren durch die Stromversorgung bzw. einen Transformator vorgegeben. Der Widerstand $R_E$ wurde dagegen willkürlich gewählt. Alle sonstigen Ströme und Spannungen ergaben sich aus diesen Größen. Die Größe des Erdschlusswiderstands lässt sich direkt aus den Werten $U_E$ und $I_E$ berechnen. In der ersten Wertespalte ist $R_E = \infty$ = kein Erdschluss, während in der letzten Spalte $R_E$ = 0 Ohm = satter Erdschluss gilt.

Bei Überschreiten eines vorgegebenen Auslösewertes löst einer der Sicherungsautomaten bzw. Trennschalter 30 bis 32, 35 aus. Über Hilfsschalterkontakte der Sicherungsautomaten oder Trennschalter 30 bis 32, 35 wird die Heizung R1, R2, R3 abgeschaltet. Die Trennung der verketteten Drosselspulen Z1, Z2, Z3 vom Erdpotential ist dann nicht mehr unbedingt notwendig, da die Heizung abgeschaltet ist. Durch die Auswahl der Sicherungsautomaten 30 bis 32, 35, d. h. durch deren Auslöseströme, ist die Empfindlichkeit der Überwachungseinrichtung vorwählbar bzw. einstellbar. Als Sicherungsautomaten werden dabei vorzugsweise handelsübliche Motorschutzschalter eingesetzt. Indem der Auslösestrom so festgelegt wird, dass die Sicherungsautomaten nicht schon bei kleinen Leckströmen ansprechen, ergibt sich eine Robustheit der erfindungsgemäßen Einrichtung.

Tritt ein Erdschluss auf der Leitung 13 auf, so ändert sich der Strom IHT3. Die Erfassung dieses Stroms zur Abschaltung der Heizung allein würde jedoch nicht genügen, weil Erdschlüsse nicht immer satt ($R_E$ = 0) auftreten.

Dies bedeutet, dass der Erdstrom $I_E$ auch bei einer Stromstärke von beispielsweise 50 A festgestellt werden muss. Der Heizungsstrom kann aber mehrere Tausend Ampère betragen, was bedeutet, dass eine Stromänderung von einigen Ampere auf einem Niveau von einigen Tausend Ampere zuverlässig mit einem Ampèremeter festgestellt werden müsste, was praktisch unmöglich ist. Außerdem wird die Heizung R1, R2, R3 temperaturgeregelt, sodass eine Stromänderung auch hier ihre Ursache haben könnte.

Durch die Verwendung der verketteten Induktivitäten Z1, Z2, Z3 wird genau erkannt, wenn eine Stromänderung auf einem Erdschluss beruht. Die verketteten Drehstromdrosseln Z1, Z2, Z3 bilden dagegen einen künstlichen Sternpunkt, der im symmetrischen Fall, d. h. wenn kein Erdschluss vorliegt, keinen Potentialunterschied zur Erde bzw. zur Masse aufweist. Ausgleichströme fließen erst dann, wenn die Symmetrie aufgrund eines Erdschlusses gestört wird.

Die Ampèremeter 27, 28, 29 dienen in der Schaltung gemäß Fig. 1 lediglich dazu, eine Information über die fließende Stromstärke zu geben. Die Abschaltung der Heizung bei Überschreiten einer vorgegebenen Stromstärke erfolgt dagegen über Hilfsschalter der Sicherungsautomaten 30 bis 32, 35. Hat einer der Sicherungsautomaten 30 bis 32, 35 ausgelöst, so wird über die Hilfsschalter der Heizung - eventuell auch über einen Thyristorsteller - abgeschaltet, und zwar zusammen mit einer eventuellen Signalisierung des Erdschlusses. $IH_3$, E in der Tabelle ist eine bei dem Versuchsaufbau gemessene Hilfsgröße, die den Strom durch die Stromdurchführung in dem Kessel oder Ofen darstellt. Sie ist gleich der Summe aus IT3 und IHT3 in Fig. 1. Bei der Berechnung wurde ein Erdschluss in Phase $L_2$ angenommen, um einfacher die Symmetrien in der Schaltung zu erkennen. Bei dem Messprotokoll wurde dagegen von einem Erdschluss in Phase $L_3$ ausgegangen.

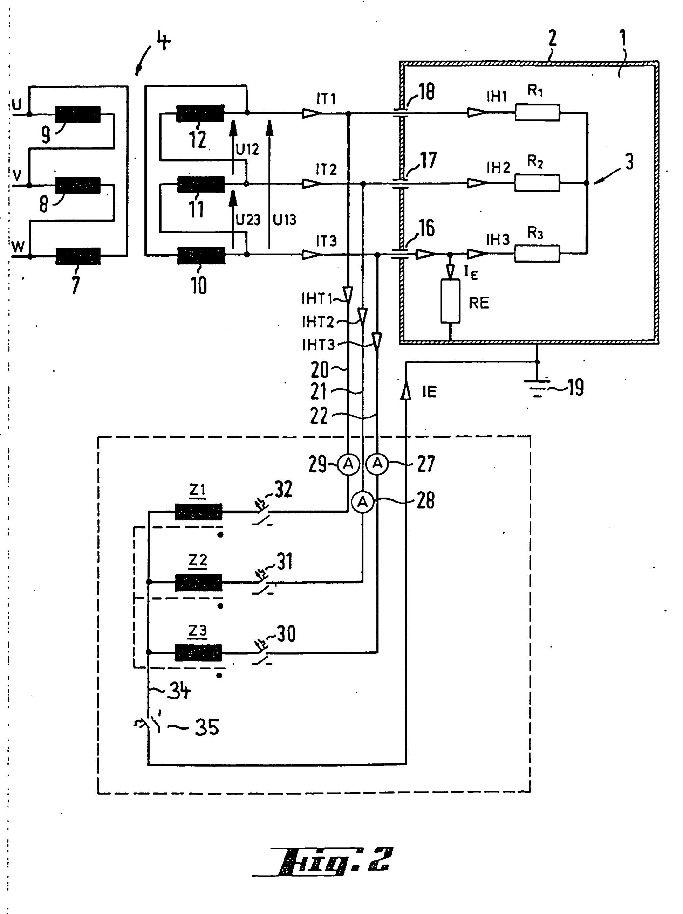

In der Fig. 1 ist der Transformator 4 im Stern geschaltet, doch muss dies nicht unbedingt so sein. Wie in der Fig. 2 dargestellt, kann der Transformator 4 auch im Dreieck-Dreieck geschaltet sein.

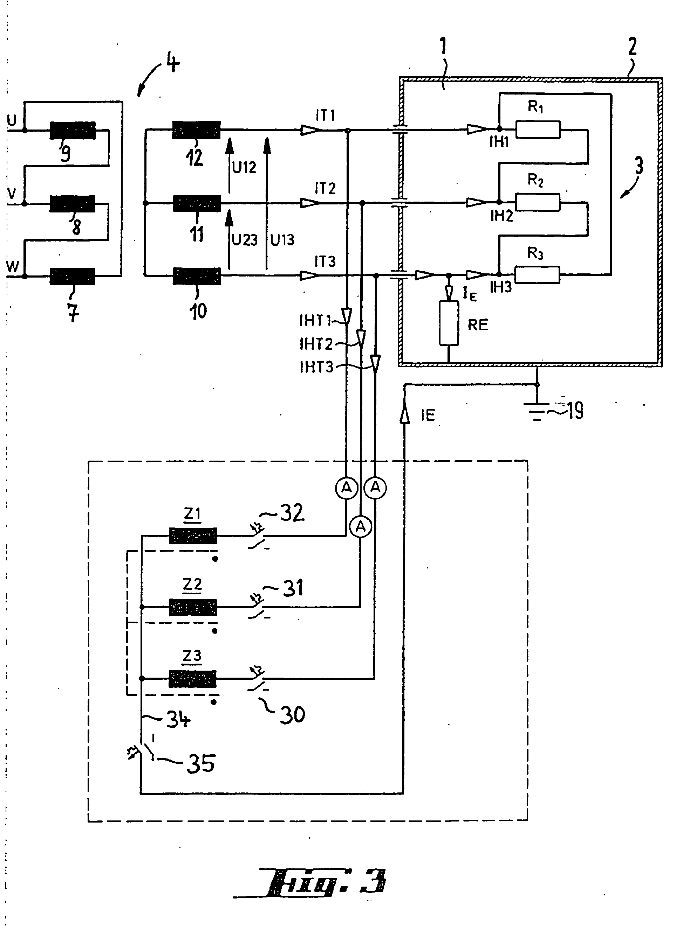

Die Fig. 3 zeigt eine Variante der Fig. 1, bei welcher die die Heizung bildendenWiderstände R1, R2, R3 im Stern geschaltet sind.

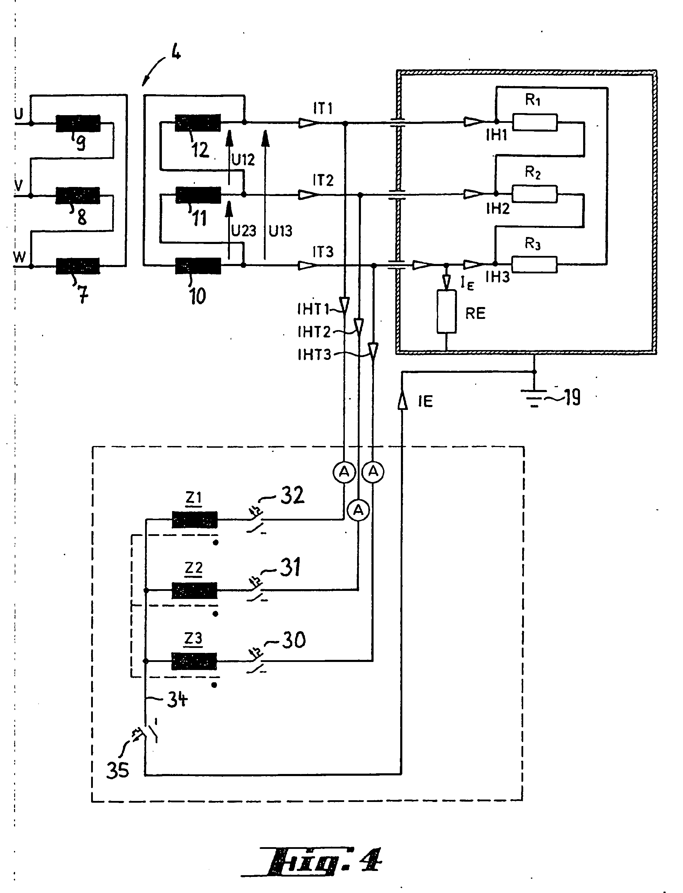

In der Fig. 4 sind sowohl die Sekundärwicklung des Transformators 4 als auch die Heizung mit den Widerständen R1, R2, R3 im Dreieck geschaltet. Die Anordnung der Drosselspulen Z1, Z2, Z3 ist die gleiche wie in Fig. 1.

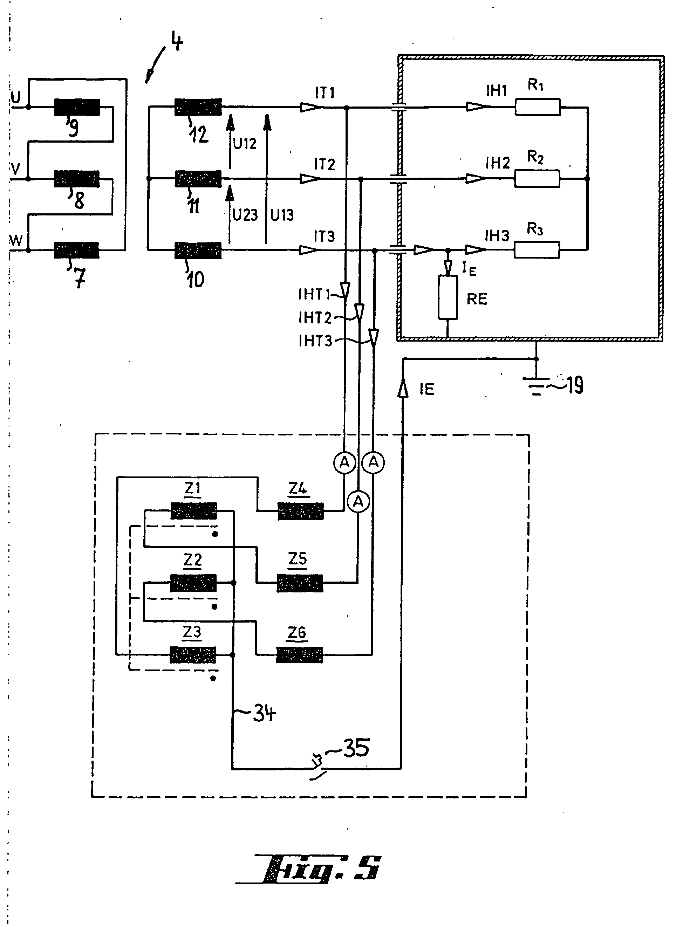

Fig. 5 zeigt einen Trafo mit sekundärseitiger Sternschaltung sowie eine Heizung in Sternschaltung. Die verketteten Drosselspulen Z1 bis Z6 sind jedoch im Zickzack geschaltet.

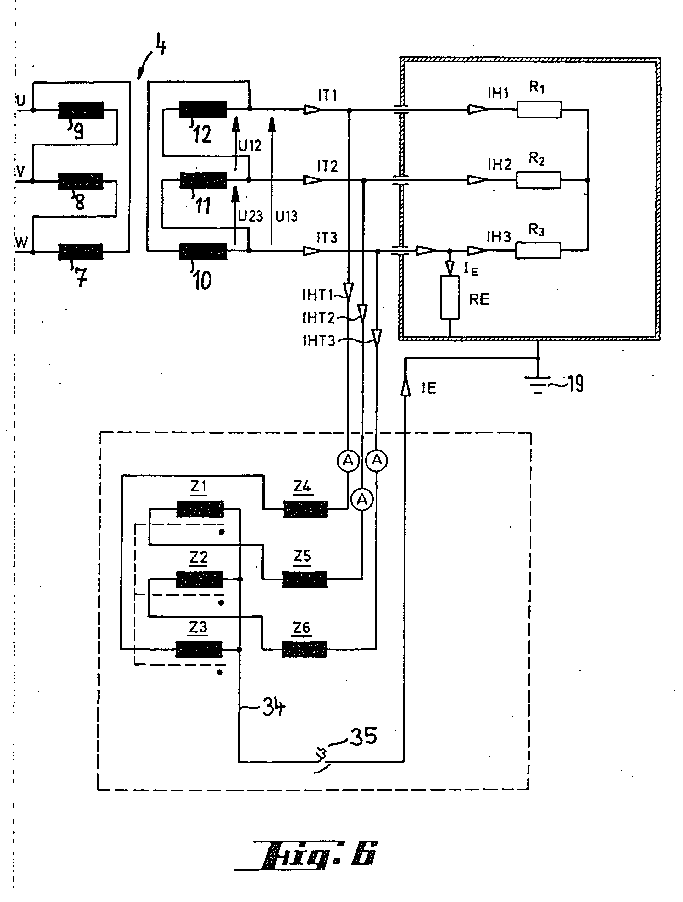

Die Schaltungsanordnung der Fig. 6 entspricht derjenigen der Fig. 5 mit der Ausnahme, dass der Transformator sekundärseitig im Dreieck geschaltet ist.

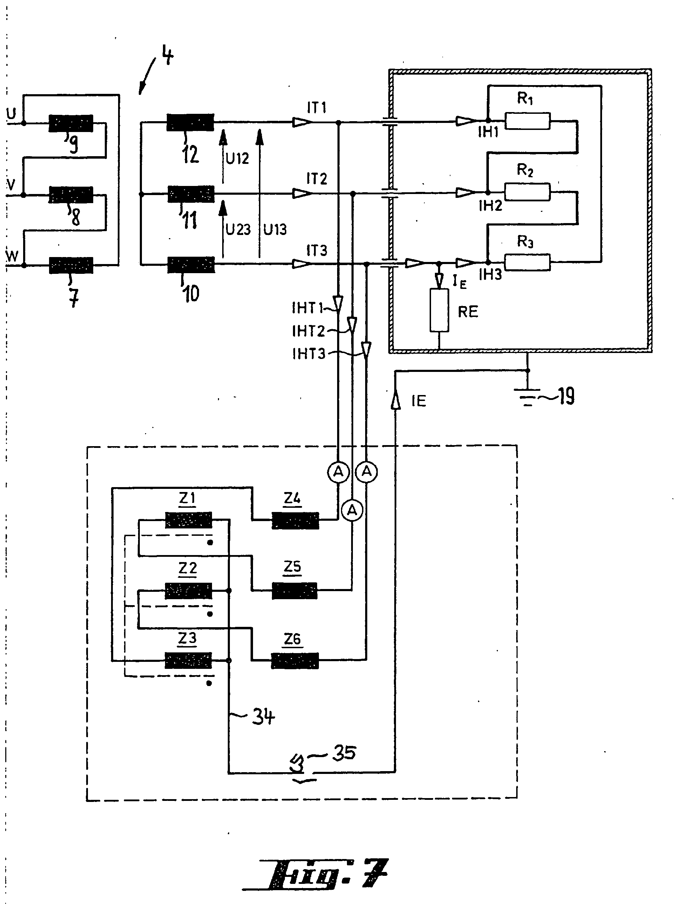

Fig. 7 entspricht der Schaltungsanordnung der Fig. 6, wobei jedoch die Sekundärseite des Trafos im Stern und die verketteten Drosselspulen Z1 bis Z6 im Zickzack geschaltet sind.

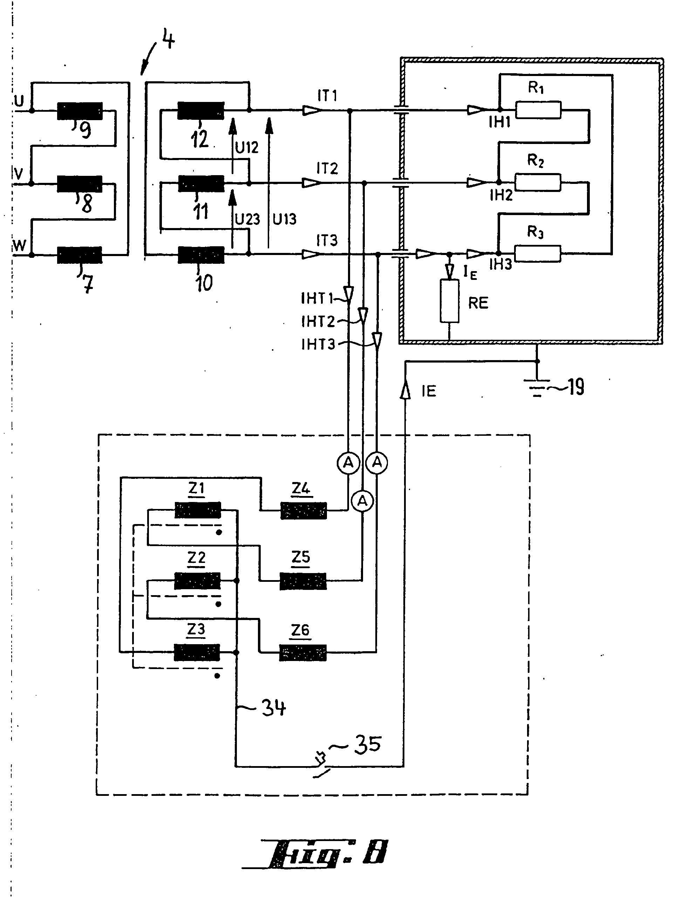

In Fig. 8 sind die Sekundärseite des Trafos und die Heizung im Dreieck und die verketteten Drosselspulen Z1 bis Z6 im Zickzack geschaltet.

**Patentansprüche**

1. Ofen mit einem dreiphasigen Heizsystem (R1, R2, R3), das von einer dreiphasigen Spannungsquelle versorgt wird, wobei es sich bei der Spannungsquelle um einen Drehstromtransformator (4) handelt, der aus einem dreiphasigen Netz gespeist ist, der Ofen ein geerdetes Gehäuse (2) aufweist und die drei Hochstrom führenden Phasen (13, 14, 15) durch die Wand des Gehäuses geführt sind, **dadurch gekennzeichnet, dass** eine Überwachungseinrichtung aus parallel zur Spannungsquelle verketteten Induktivitäten (Z1, Z2, Z3) vorgesehen ist, die eine Sternschaltung aus drei Drosselspulen bilden, wobei jede Drosselspule in einer Reihe mit jeweils einem Sicherungsautomaten (30, 31, 32) liegt, wobei die Auslöseströme der Sicherungsautomaten (30, 31, 32) die Empfindlichkeit der Überwachungseinrichtung bestimmen, wobei der Sternpunkt (33) der Sternschaltung mit dem Gehäuse (2) des Ofens verbunden ist, und dass die Sicherungsautomaten (30, 31, 32) mit Hilfsschaltern versehen sind, mit denen das Heizsystem abschaltbar ist.

2. Ofen nach Anspruch 1, **dadurch gekennzeichnet, dass** das dreiphasige Heizsystem (R1, R2, R3) im Stern geschaltet ist.

3. Ofen nach Anspruch 1, **dadurch gekennzeichnet, dass** in den Zuleitungen zu den Drosselspulen (Z1 Z2, Z3) Amperemeter (27, 28, 29) vorgesehen sind.

4. Ofen nach Anspruch 1, **dadurch gekennzeichnet, dass** die dreiphasige Spannungsquelle (4) sekundärseitig im Stern geschaltet ist.

5. Ofen nach Anspruch 1, **dadurch gekennzeichnet, dass** die dreiphasige Spannungsquelle (4) sekundärseitig im Dreieck geschaltet ist.

6. Ofen nach Anspruch 1, **dadurch gekennzeichnet, dass** die dreiphasige Spannungsquelle (4) primärseitig im Dreieck geschaltet ist.

**Claims**

1. A furnace comprising a three-phase heating system (R1, R2, R3) which is supplied by a three-phase voltage source, the voltage source being a three-phase transformer (4) which is supplied from a three-phase mains supply, the furnace comprising an earthed housing (2) and the three phases (13, 14, 15) supplying high voltage being guided through the wall of the housing, **characterised in that** a monitoring device consisting of a chain of inductances (Z1, Z2, Z3) in parallel with the voltage source is provided, said inductances forming a star connection consisting of three choke coils, each choke coil being located in series with one respective safety cut-out device (30, 31, 32), the tripping currents of the safety cut-out devices (30, 31, 32) determining the sensitivity of the monitoring device, the neutral point (33) of the star connection being connected to the housing (2) of the furnace and **in that** the safety cut-out devices (30, 31, 32) are provided with auxiliary switches, by which the heating system may be switched off.

2. The furnace according to Claim 1, **characterized in that** the three-phase heating system (R1, R2, R3) is star-connected.

3. The furnace according to Claim 1, **characterized in that** ammeters (27, 28, 29) are provided in the supply lines to the choke coils (Z1, Z2, Z3).

4. The furnace according to Claim 1, **characterized in that** the three-phase voltage source (4) is star-connected on the secondary side.

5. The furnace according to Claim 1, **characterized in that** the three-phase voltage source (4) is delta-connected on the secondary side.

6. The furnace according to Claim 1, **characterized in that** the three-phase voltage source (4) is delta-connected on the primary side.

**Revendications**

1. Four doté d'un système de chauffage (R1, R2, R3) triphasé, qui est alimenté par une source de tension triphasée, sachant que, en ce qui concerne la source de tension, il s'agit d'un transformateur triphasé (4), qui est alimenté à partir d'un réseau triphasé, lequel four présente un carter (2) relié à la terre et les trois phases (13, 14, 15) véhiculant du courant fort sont guidés à travers la paroi du carter, **caractérisé en ce qu'**un dispositif de contrôle à base d'inductances (Z1, Z2, Z3) connectées parallèlement à la source de tension est prévu, lesquelles forment un circuit en étoile constitué de trois bobines d'inductance, chaque bobine d'inductance étant disposée dans une rangée avec respectivement un coupe-circuit automatique (30, 31, 32), les courants de déclenchement des coupe-circuits automatiques (30, 31, 32) déterminant la sensibilité du dispositif de contrôle, le point neutre (33) du circuit en étoile étant relié au carter (2) du four, et **caractérisé en ce que** les coupe-circuits automatiques (30, 31, 32) sont dotés de commutateurs auxiliaires qui permettent de déconnecter le système de chauffage.

2. Four selon la revendication 1, **caractérisé en ce que** le système de chauffage (R1, R2, R3) triphasé est monté dans l'étoile.

3. Four selon la revendication 1, **caractérisé en ce que** des ampèremètres (27, 28, 29) sont prévus dans les arrivées des bobines d'inductance (Z1, Z2, Z3).

4. Four selon la revendication 1, **caractérisé en ce que** la source de tension (4) triphasée est montée côté secondaire dans l'étoile.

5. Four selon la revendication 1, **caractérisé en ce que** la source de tension (4) triphasée est montée côté secondaire dans le triangle.

6. Four selon la revendication 1, **caractérisé en ce que** la source de tension (4) triphasée est montée côté primaire dans le triangle.

*Fig. 1*

Fig.2

*Fig. 3*

*Fig. 4*

_Fig. 5_

*Fig. 6*

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US PS5811767 A
- DE 3921063 C1
- EP 0291156 A1
- US 3764855 A